# EUROPÄISCHE PATENTSCHRIFT

(11) **EP 3 376 100 B1**
(45) Veröffentlichungstag und Bekanntmachung des Hinweises auf die Patenterteilung: **29.10.2025**
(21) Anmeldenummer: 18162323.2
(22) Anmeldetag: 16.03.2018
(51) Int. Cl.: F21V 17/10, F21Y 115/10, F21Y 103/10

(54) **LED-LEUCHTENMODUL MIT FLÄCHIGEM TRÄGER FÜR LEDS**
LED LIGHT MODULE WITH A FLAT HOLDER FOR LEDS
MODULE D'ÉCLAIRAGE LED DOTÉ DU SUPPORT PLAT POUR LED

(30) Priorität: 16.03.2017 DE 102017105722
(43) Veröffentlichungstag der Anmeldung: 19.09.2018
(73) Patentinhaber: SITECO GmbH, 83301 Traunreut (DE)
(72) Erfinder: Holzbauer, Jochen, 83278 Traunstein (DE); Prodell, Peter, 83308 Trostberg (DE); Wuppinger, Bernhard, 83362 Surberg (DE); Kronast, Martin, 83137 Schonstett (DE)
(74) Vertreter: Schmidt, Steffen

(56) Entgegenhaltungen:
- EP-A1- 1 767 849
- EP-A2- 3 222 902
- WO-A1-2010/016950
- DE-A1- 102009 054 840
- US-A1- 2012 201 023
- US-A1- 2014 321 110
- US-A1- 2015 233 533

## Beschreibung

Die Erfindung betrifft ein LED-Leuchtenmodul, welches z.B. zum Einsatz in Innen- oder Außenleuchten für Beleuchtungszwecke eingerichtet ist oder als vollständige Leuchte ausgebildet ist, und insbesondere ein LED-Leuchtenmodul, welches einen flächigen Träger aufweist, der mit LEDs (Light Emitting Diodes, worunter jede Art von Halbleiterlichtquellen zu verstehen ist) bestückt ist.

Im Stand der Technik ist es üblich, für Leuchten mit LEDs als Leuchtmittel die LEDs in einem Modul zusammenzufassen, welches in die Leuchte integriert wird oder selbst als Leuchte verwendet werden kann. Das LED-Leuchtenmodul umfasst einen Träger für die LEDs in Form einer Leiterplatte, auch als Printed Circuit Board bezeichnet, welche nicht nur die LEDs trägt sondern ferner auch für die elektrische Kontaktierung der LEDs eingerichtet ist. Ein Beispiel eines solchen Beleuchtungskörpers ist in der DE 20 2009 011 688 U1 beschrieben. Die LEDs sind auf einer Leiterplatte angeordnet, wobei die Leiterplatte ggf. auch als Metallkernleiterplatte ausgeführt ist, um die von den LEDs erzeugten Wärme besser ableiten zu können. In diesem Beispiel dient die Leiterplatte selbst als Rückwand für den Beleuchtungskörper.

Ein weiteres Beispiel einer LED-Leuchtvorrichtung ist in DE 10 2008 039 364 A1 beschrieben. Der LED-Träger dieser Beleuchtungsvorrichtung umfasst ein keramisches Substrat oder eine Metallkernplatine. Der LED-Träger ist in diesem Fall thermisch mit einem Kühlkörper verbunden.

Ein Nachteil der genannten Module ist jedoch, dass eine mit LEDs bestückte Leiterplatte verhältnismäßig kostenintensiv ist sowohl aufgrund der Materialien als auch der Herstellung. Es kommt noch erschwerend hinzu, dass aufgrund einer notwendigen thermischen Kühlung der LEDs in der Regel Metallkernleiterplatten verwendet werden müssen, die noch teurer als gewöhnliche Kunststoffleiterplatten sind.

EP 3 222 902 A2, welche als Stand der Technik nur nach Art. 54(3) EPÜ zu berücksichtigen ist, offenbart eine LED-Platine für eine Leuchte sowie ein zugehöriges Herstellungsverfahren. Die Platine kann aus einem Halbzeug hergestellt werden, bei dem es sich um ein mit einer Lackschicht versehenes Blech Coil handelt.

DE 10 2009 054 840 A1 offenbart Leuchtmittel mit mehreren Leuchtdioden, die jeweils elektrische Anschlüsse aufweisen, und eine Trägerfolie, auf die die Leuchtmittel aufgebracht sind und die wenigstens eine elektrisch isolierende Oberfläche aufweist.

WO 2010/016950 A1 offenbart ein individuelles Lichtschild, auf welchem eine Reihe von LEDs angebracht sind. Ein nicht reflektierender Film und ein reflektierendes Material sind über einen Teil der Oberfläche des Lichtschilds angebracht.

US 2014/321110 A1 offenbart eine Lichtröhre mit einem Lichtstab und einer wärmeableitenden Struktur. Der Lichtstab und die wärmeableitende Struktur sind eine einstückig ausgebildete integrale Struktur, die zusammen eine Hohlröhre bildet.

DE 10 2009 054840 A1 offenbart eine Leuchteneinrichtung entsprechend dem Oberbegriff des Anspruchs 1.

Aufgabe der vorliegenden Erfindung ist es, eine kostengünstige Variante eines LED-Leuchtenmoduls bereitzustellen, das einfach aufgebaut ist und den besonderen thermischen Anfordernissen, die LEDs als Leuchtmittel erfordern, gerecht wird.

Gelöst wird die Aufgabe durch ein LED-Leuchtenmodul nach Anspruch 1 und ein Herstellungsverfahren nach Anspruch 15.

Eine Besonderheit des LED-Leuchtenmoduls gemäß der vorliegenden Erfindung besteht in der Ausgestaltung des flächigen Trägers der LEDs aus einem lackierten Metallblech. Ein kostengünstig herstellbares Metallblech kann die Leiterplatte als klassischen Träger der LEDs ersetzen. Das Metallblech ist gegenüber den LEDs, die darauf angebracht sind, durch eine Lackierung elektrisch isoliert. Die Lackierung kann kostengünstig an dem Blech hergestellt werden, genügt jedoch den Anfordernissen für die notwendige elektrische Isolierung für ein Leuchtenmodul. Ferner kann die Lackierung auch für weitere Funktionen in dem Leuchtenmodul, insbesondere als Reflektorfläche genutzt werden. Ferner kann das Blech in eine gewünschte Form gebracht werden, was bei einer herkömmlichen Leiterplatte mit oder ohne Metallkern nicht ohne weiteres möglich ist.

Erfindungsgemäß ist der Träger auf der wenigstens einen Oberflächenseite bandlackiert. Eine Bandlackierung, auch als Walzenbeschichtung bezeichnet, lässt sich in der großindustriellen Fertigung einfach herstellen und eignet sich zur Erzeugung einer dünnen, homogenen und sogar hochglänzenden Lackschicht auf dem Metallblech. Ferner hat die Bandlackierung den Vorteil, dass die Verbindung zwischen der lackierten Isolierschicht und dem Blech derart ausgebildet ist, dass sogar das lackierte Blech nachträglich noch umgeformt werden kann, ohne dass eine Beschädigung der Lackschicht auftritt.

Erfindungsgemäß beträgt die Schichtdicke der Lackierung zwischen 5 µm und 80 µm, insbesondere zwischen 10 µm und 35 µm. Die dünne Lackschicht ist ausreichend, um die notwendige elektrische Isolierung bereitzustellen. Ferner neigt eine dünne Lackierung nicht zur Rissbildung, wenn das Material mechanischen oder thermischen Einflüssen unterliegt. Als Materialien für die Lackierung sind allgemein kohlenstoffbasierte Polymere, Polyurethan, Polyester und Epoxyphenol basierte Materialien bevorzugt. Ggf. dazu benötigte Bindemittel können auf Basis von Polyesterharz, Melamin, Acrylat oder auch Alkydharz sein.

Gemäß einer bevorzugten Ausführungsform ist die Lackierung reflektierend ausgebildet. Dadurch kann das Metallblech auch als Reflektor für die Leuchte genutzt werden.

Gemäß einer bevorzugten Ausführungsform sind die LEDs mittels auf die Lackierung aufgebrachten metallischen Leiterbahnen elektrisch kontaktiert. Die Leiterbahnen sind von dem Metallblech auch durch die Lackierung elektrisch isoliert. Insbesondere lassen sich durch Aufdrucken auch Leiterbahnen sogar auf nicht ebenen Blechen realisieren. Die Leiterbahnen können eine Schichtdicke zwischen 10 µm und 100 µm aufweisen. Derartige Leiterbahnen sind auch geeignet, um das Metallblech nach der Bestückung mit LEDs und der Leiterbahn noch umzuformen, ohne dass die Leiterbahnen Schaden nehmen. Als Materialien für die Leiterbahnen sind insbesondere Kupfer, Gold, Aluminium, Weißblech, metallische Legierungen und elektrisch leitfähige Pasten (z.B. mit Silber gefüllt) bevorzugt. Sollte eine durchgängige reflektierende Oberfläche des Trägers gefordert sein, kann auch ein reflektierender Lötstopplack auf die Leiterbahn aufgebracht werden.

Gemäß einer bevorzugten Ausführungsform weist das LED-Leuchtenmodul ferner eine Abdeckung aus einem wenigstens teilweise transparenten Material (insbesondere aus einem transparenten Kunststoff wie PMMA oder PU) auf und die Abdeckung ist gegenüberliegend der wenigstens eine Oberflächenseite angeordnet, so dass das Licht der LEDs überwiegend oder vollständig durch die Abdeckung hindurchtritt. Dabei ist von Vorteil, dass die Abdeckung zusammen mit dem Träger in einem LED-Leuchtenmodul integriert ist, weil über die Lebenszeit des LEDs-Moduls in der Regel die LEDs nicht ausgetauscht werden müssen. Es ist jedoch möglich, dass die Teile auch voneinander trennbar sind. Die transparente Abdeckung kann gleichzeitig zwei Funktionen übernehmen. Zum einen kann die Abdeckung lichtlenkende Eigenschaften aufweisen, um eine gewünschte Lichtverteilung des LED-Leuchtenmoduls zu erzeugen. Ferner kann die Abdeckung auch einen Schutz für die LEDs und weitere elektrische Komponenten bieten. Dieser Schutz kann ein Berührschutz sein. Bei LED-Modulen ist es wichtig, dass die stromführenden Teile nicht zugängig sind. Auch die Berührung mit einem Werkzeug, wie z.B. einem Schraubendreher oder eine Draht, soll unterbunden werden. Dies lässt sich dadurch erreichen, dass die Abdeckung gegenüber dem flächigen Träger so angebracht ist, dass keine Spalten mit mehr als 2 mm, vorzugsweise 0,5 mm, gebildet werden. Ferner kann die Abdeckung auch vor Feuchtigkeit oder Staub schützen. Dies ist insbesondere für Leuchtenmodule, die bei Außenleuchten oder Feuchtraumleuchten Verwendung finden, von Vorteil. Es lässt sich die erforderliche Schutzklasse kostengünstig herstellen.

Gemäß einer bevorzugen Ausführungsform ist der flächige Träger durch einen Formschluss und/oder einen Kraftschluss mit der Abdeckung verbunden, insbesondere in Vor- und/oder Rücksprünge der Abdeckung eingeschoben oder eingeklemmt. Es kann auch vorgesehen sein, dass die Abdeckung mit dem flächigen Träger verklebt ist oder durch separate mechanische Befestigungsmittel verbunden ist. Vorzugsweise ist der flächige Träger mit der Abdeckung derart verbunden, dass ein oder mehrere Ränder des flächigen Trägers abgedeckt werden. Insbesondere können Ränder in Vertiefungen der Abdeckung eingeschoben bzw. eingeklemmt sein, so dass die Abdeckung nicht nur mechanisch gehalten ist, sondern außerdem einen Berührschutz auf die Ränder gewährleistet ist. Die Ränder sind bei den eingesetzten Trägern häufig scharfkantig, wenn die Träger durch Ausstanzen hergestellt werden. In diesem Bereich ist daher die schützende Isolierung gestört. Für den Fall, dass der Träger spannungsführend ist, muss daher aus Sicherheitsgründen ein Berührschutz gewährleistet werden. Dies kann bei der bevorzugten Ausführungsform leicht dadurch erzielt werden, dass die Ränder im Träger derart gehalten sind, so dass sie von außen nicht berührt werden können. Beispielsweise können die Ränder in Vertiefungen, insbesondere in länglichen Nuten, eingeschoben sein, so dass der Spalt zwischen der Isolierung des Trägers und der angrenzenden Seitenwand des Trägers so gering ist, dass ein Berühren des Randes des Trägers auch mit einem Draht oder einem Schraubenzieher wirksam verhindert wird. Die Abdeckung kann insbesondere durch eine spritzgegossene Kunststoffabdeckung, z.B. in Form einer Wanne, gebildet sein. Vorzugsweise sind in der Abdeckung die Vertiefungen für die Stirnseiten des flächigen, ggf. mit umgeformten Randbereichen ausgebildeten Trägers integriert. Alternativ kann die Abdeckung auch aus einem Glas gebildet sein. Die Abdeckung kann z.B. mit Klammern oder durch Verkleben mit dem Träger, insbesondere mit den Rändern des Trägers, verbunden sein. Alternativ oder zusätzlich kann die Abdeckung auch mit Befestigungselementen an dem Träger gesichert sein, die auf die gleiche Weise wie die LEDs am Träger befestigt sind, z.B. Metalldome, auf welchen die Abdeckung angebracht wird. Die Abdeckung kann auch integrierte Linsen- oder Prismenelemente aufweisen, welche durch die Befestigung an dem Träger gegenüber den LEDs ausgerichtet sind.

Erfindungsgemäß weist der Träger eine konkave oder konvexe Krümmung auf. Die Krümmung kann durch Einklemmen des Trägers, z.B. in eine Abdeckung, erreicht werden. Die Breite des Trägers legt dabei die Stärke der Krümmung fest. Diese Ausführungsform ist in Verbindung mit einer reflektierenden Lackierung von Vorteil, weil die gewünschte konkave oder konvexe Krümmung einen entsprechenden Reflektor erzeugt. Insbesondere kann sich die Krümmung großflächig über den gesamten Träger erstrecken. Beispielsweise kann der gesamte Träger oder wenigstens ein Teil des Trägers, der ein Vielfaches der räumlichen Ausdehnung der LEDs (z.B. das 10-fache) umfasst, gekrümmt sein. Dadurch kann der als Reflektor dienende Träger das Licht mehrerer LEDs, die darauf angebracht sind, gemeinsam umlenken. Dem gegenüber sind Anordnungen, in denen nur lokal gekrümmte Reflektorflächen für jeweils eine LED vorgesehen sind, aufwendiger herzustellen und erfordern auch einen größeren Aufwand, um die LEDs elektrisch kontaktieren zu können.

Gemäß einer bevorzugten Ausführungsform sind an dem Träger Steckverbindungen vorgesehen, die sich durch den Träger von der wenigstens einen Oberflächenseite mit den LEDs auf die entgegengesetzte Seite erstrecken und dafür eingerichtet sind, den Träger elektrisch anzuschließen und/oder mit mechanisch an einer Leuchtenkomponente zu halten. Beispielsweise können Steckkontakte durch Öffnungen oder durch Randausschnitte des Metallblechträgers geführt sein, die auf der die LEDs tragenden Seite mit elektrischen Leiterbahnen verbunden sind und einen elektrischen Anschluss auf der entgegengesetzten Seite des Trägers bereitstellen. Der Träger kann beispielsweise in entsprechende Sockel in einem Leuchtengehäuse oder Modulgehäuse eingesteckt werden. Diese Steckelemente können auch die Funktion übernehmen, den Träger bzw. das gesamte Leuchtenmodul mechanisch zu halten. Es können auch einige Steckverbinder oder alle Steckverbinder nur zum mechanischen Halten des Trägers bzw. des LED-Leuchtenmoduls dienen.

Gemäß einer bevorzugten Ausführungsform sind auf der wenigstens einen Oberflächenseite neben den LEDs weitere elektrische Komponenten, insbesondere ein LED-Treiber, vorgesehen. Dabei kann vorgesehen sein, dass die elektrischen Komponenten in einem Abstand zu den LEDs angeordnet sind, so dass der Abstrahlwinkel der LEDs durch die weiteren elektrischen Komponenten nicht oder weniger als 10° eingeschränkt ist. Mit anderen Worten ausgedrückt, die elektrische Komponente ist mindestens in einem solchen Abstand zu der LED angeordnet, dass ein von der LED ausgehender Lichtstrahl, der einen Winkel gegenüber dem Träger von mehr als 10° aufweist, nicht auf die elektronischen Komponente auftrifft. Der minimale Abstand zwischen den LEDs und den weiteren elektrischen Komponenten hängt daher auch von der Höhe der elektrischen Komponente und von dem Biegeradius des flächigen Trägers ab. Die Anordnung der elektronischen Komponenten auf dem Träger hat den Vorteil, dass die elektronischen Komponenten über die Leiterbahnen auf dem Träger direkt mit den LEDs verbunden werden können. Durch die Anbringung der elektrischen Komponenten auf der mit den LEDs besetzten Seite braucht keine aufwendige elektrische Durchführung zu der Rückseite des aus Metallblech gebildeten Trägers eingerichtet zu werden. Es können alle elektrischen Verbindungen nur auf einer Seite des Trägers mit den LEDs vorgesehen sein, ggf. abgesehen von elektrischen Durchführungen der vorhergehend genannten Steckverbinder.

Gemäß einer bevorzugten Ausführungsform ist der flächige Träger an einem oder an mehreren Rändern umgeformt. Durch das Umformen, z.B. Umbörteln des Randes, kann die Stabilität des Bleches erhöht werden. Ferner kann der Rand gleichzeitig auch in eine Form gebracht werden, die dafür geeignet ist, mit Vor- und/oder Rücksprüngen eines angrenzenden Bauteils des Moduls, z.B. der Abdeckung, zusammenzuwirken, um den Träger an dem Bauteil mechanisch zu halten. Beispielsweise können die Ränder auf die den LEDs abgewandten Seite umgebogen sein und in eine entsprechende Vertiefung eines Gehäuses oder einer Abdeckung hineingeschoben oder eingeklemmt sein. In einer weiteren Ausführungsform sind die Randbereiche des Trägers in Richtung zu der Flächennormalen der mit den LEDs besetzten Seiten der Träger umgebogen, z.B. um ein Gehäuse und/oder einen Reflektor zu bilden.

Gemäß einer bevorzugten Ausführungsform ist der Träger streifenförmig oder ringförmig ausgebildet. Dadurch lassen sich in kostengünstiger Weise längliche oder kreisförmige LED-Leuchtenmodule erzeugen.

Gemäße einer bevorzugten Ausführungsform weist der Träger eine Stärke zwischen 0,3 mm und 1,2 mm, insbesondere zwischen 0,4 mm und 0,9 mm, auf. Die Wandstärke ist für Metallbleche vollkommen ausreichend, um die notwendige Stabilität aufzubringen. Dabei ist zu beachten, dass Wandstärken wesentlich dünner als herkömmliche LED-Leiterplatten ausgeführt werden können.

Gemäß einer weiteren bevorzugten Ausführungsform kann der flächige Träger auf der den LEDs entgegengesetzten Seite mit einem Gehäusebauteil verklebt sein. Beispielsweise ist es möglich, den Träger flächig in ein Leuchtengehäuse einzukleben, insbesondere mit einer beidseitig klebenden Folie. Hierfür ist eine Folie mit isolierenden Eigenschaften, z.B. Kapton, besonders geeignet. Dabei ist von Vorteil, dass alle elektrischen Komponenten auf der der zu verklebenden Seite abgewandten Oberfläche des Träger angebracht sein können. Ferner kann der Träger sogar auf gekrümmte Oberflächen eines Gehäuseportals aufgeklebt werden. Von Vorteil ist ferner, wenn die Verklebung zwischen dem Träger und dem angrenzenden Leuchtenportal vollflächig ist, weil dann auch ein guter thermischer Kontakt zwischen dem metallischen Träger und den angrenzenden Bauteil, welches ggf. als Kühlkörper wirken kann, gegeben ist.

Wie in den verschiedenen Ausführungsformen vorhergehend beschreiben, kann der Träger mit einer Gehäusekomponente verbunden sein. In Ausführungsformen, welche eine Abdeckung aufweisen, kann jedoch alternativ oder zusätzlich auch die Abdeckung mit einer Gehäusekomponente verbunden sein. Beispielsweise kann die Abdeckung hakenförmige Ansätze aufweisen, die in den entsprechenden Hinterschneidungen eines Gehäuseprofils eingreifen.

Weitere Merkmale und Vorteil der vorliegenden Erfindung werden aus der nachfolgenden Beschreibung bevorzugten Ausführungsformen deutlich, die in Verbindung mit den beigefügten Figuren gegeben wird. In den Figuren ist Folgendes dargestellt:
- Figur 1: zeigt eine Seitenansicht eines Abschnitts eines LED-Leuchtenmoduls gemäß einer ersten Ausführungsform.
- Figur 2: zeigt eine Seitenansicht eines LED-Leuchtenmoduls gemäß einer weiteren Ausführungsform.
- Figur 3: zeigt eine Seitenansicht eines LED-Leuchtenmoduls gemäß einer weiteren Ausführungsform.
- Figur 4: zeigt eine perspektivische Ansicht des Trägers des LED-Leuchtenmoduls nach Figur 3.
- Figur 5: zeigt eine Seitenansicht des Trägers nach Figur 4.
- Figur 6: zeigt ein LED-Leuchtenmodul gemäß der Erfindung.
- Figur 7: zeigt ein weiteres LED-Leuchtenmodul gemäß der Erfindungmit konkav gebogenem Träger.
- Figur 8: zeigt ein weiteres LED-Leuchtenmodul gemäß der Erfindung.mit konvex gebogenem Träger.
- Figur 9: zeigt eine perspektivische Ansicht eines Trägers einer weiteren Ausführungsform eines Leuchtenmoduls.
- Figur 10: zeigt eine perspektivische geschnittene Ansicht eines LED-Leuchtenmoduls mit dem Träger nach Figur 9.
- Figur 11: zeigt eine Aufsicht auf einen flächigen Träger gemäß einer weiteren Ausführungsform.
- Figur 12: zeigt den Träger nach Figur 11 mit bestückten LEDs und einem integrierten Treiber.
- Figur 13: zeigt eine perspektivische Ansicht des Trägers nach Figur 12 mit umgeformten Randbereichen.
- Figur 14: zeigt den Träger nach Figur 13 mit einer aufgesetzten transparenten Abdeckung.
- Figur 15: zeigt eine Aufsicht auf einen mit LEDs bestückten Träger gemäß einer weiteren Ausführungsform.
- Figur 16: zeigt eine perspektivische Ansicht des Trägers nach Figur 15 mit umgeformten Randbereichen gemäß der Erfindung.
- Figur 17: zeigt einen Querschnitt durch eine Leuchte mit dem Träger nach Figur 16 gemäß der Erfindung, welche in einem Gehäuse integriert ist und mit einer Abdeckung versehen ist.
- Figur 18: zeigt eine perspektivische Ansicht eines Träger mit LEDs und umgeformten Randbereichen gemäß der Erfindung.
- Figur 19: zeigt einen Querschnitt durch den Träger nach Figur 18 gemäß der Erfindung mit einer Abdeckung in Form einer Primäroptik.

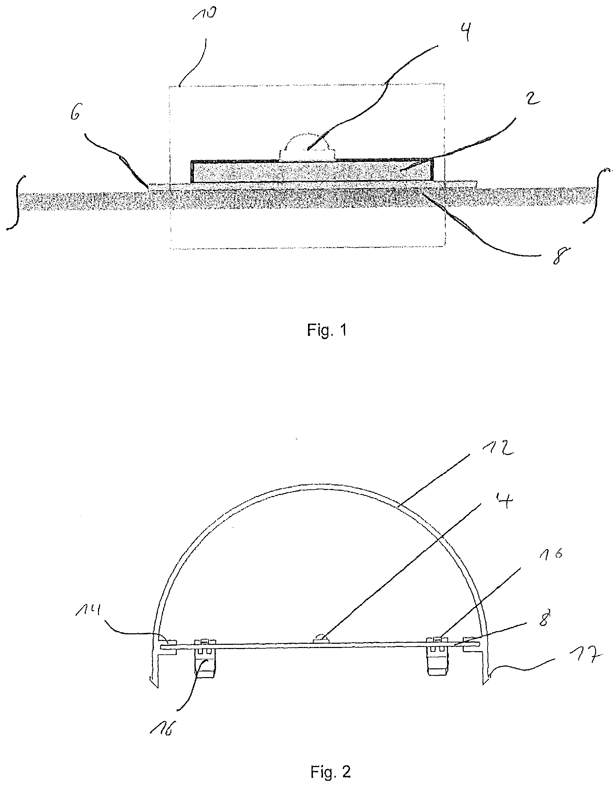

Bezugnehmend auf die Figur 1 wird eine erste Ausführungsform eines LED-Leuchtenmoduls erläutert. Das Leuchtenmodul umfasst einen Träger 2, der flächig ausgebildet ist und aus einem Metallblech hergestellt ist. Der Träger ist vorzugsweise ein bandlackiertes Stahlblech (allerdings sind andere Metalle wie z.B. Aluminium möglich), da dieses Material sehr gute reflektierende Eigenschaften aufweist und dabei extrem kostengünstig hergestellt werden kann. Das Stahlblech besitzt eine Stärke von etwa 0,7 mm während die Lackierung eine Schichtdicke von weniger als 50 µm aufweist. Die Lackierung ist aus einem elektrisch isolierenden Material (z.B. kohlenstoffbasierte Polymere) hergestellt. Der lackierte Träger 2 ist direkt mit einer Reihe von LEDs 4 (wovon in der Figur 1 in der Seitenansicht nur eine zu sehen ist) bestückt. Ferner sind Leiterbahnen (in den Figuren nicht dargestellt) direkt auf den Lack des Trägers aufgebracht, z.B. mit einem Kupferauftrag durch ein Plasmaverfahren oder durch einen Auftrag einer elektrisch leitenden Phase mit einem Schablonendruck und anschließender thermischer Aushärtung. Die Leiterbahnen dienen dazu, die LEDs 4 elektrisch zu kontaktieren.

Der Träger 2 ist in der in Figur 1 dargestellten Ausführungsform mittels einer beidseitig klebenden Folie 6 auf einem Abschnitt eines Gehäusebodens 8 flächig aufgeklebt. Der Gehäuseboden 8 ist der Figur 1 nur in einem Teilabschnitt dargestellt. Die Folie 6 kann beispielsweise eine Stärke von unter 200 µm aufweise. Beispielsweise kann das Material DuPont Kapton NH der Stärke 25 µm verwendet werden. Kapton hat den Vorteil, dass es sehr gute elektrische isolierende Eigenschaften aufweist. Das Gehäuse 8 kann beispielsweise aus Kunststoff oder einem Strangpressprofil aus Metall gebildet sein.

In der Figur 1 ist schematisch durch das Rechteck 10 angedeutet, dass der Träger 2, der darauf befindliche Träger 2 sowie die LEDs 4 mit einem Berührschutz umgeben sind. Dieser Berührschutz kann beispielsweise durch eine Abdeckung in Verbindung mit Gehäusebauteilen gebildet werden.

Figur 2 zeigt eine alternative Ausführungsform eines LED-Leuchtenmoduls. In dieser Ausführungsform ist der Träger 2 nicht auf eine Gehäusewand 8 geklebt, wie in der Ausführungsform nach Figur 1, sondern freitragend in einer Abdeckung 12 angeordnet. Die Abdeckung 12 ist aus einem transparenten Kunststoff gebildet und weist auf der Innenseite zwei gegenüberliegende Nuten 14 auf, in welche der Träger 2 der Länge nach eingeschoben ist. An dem Träger 2 sind in dieser Ausführungsform ferner noch Steckverbinder 16 vorgesehen, die in Öffnungen des Trägers 2 eingefügt sind. Auf der Oberflächenseite mit den LEDs 4 sind die Steckverbinder 16 elektrisch mit den Leiterbahnen, welche die LEDs 4 kontaktieren, verbunden. Auf der den LEDs entgegengesetzten Seite weisen die Steckverbinder einen Sockel auf, der dafür geeignet ist, in einen gegenüberliegenden Stecker (in den Figuren nicht dargestellt), der sich z.B. in einem Gehäuseboden befindet, eingesteckt zu werden und dadurch das LED-Leuchtenmodul sowohl mechanisch zu halten als auch elektrisch anschließen. Ferner weist die Abdeckung 12 in dieser Ausführungsform an den äußeren Enden eine hakenförmige Kontur 14 auf, die dafür geeignet ist, ebenfalls in Vertiefungen eines gegenüberliegenden Gehäuseportals eingesteckt zu werden, um das LED-Leuchtenmodul zusätzlich mechanisch zu sichern.

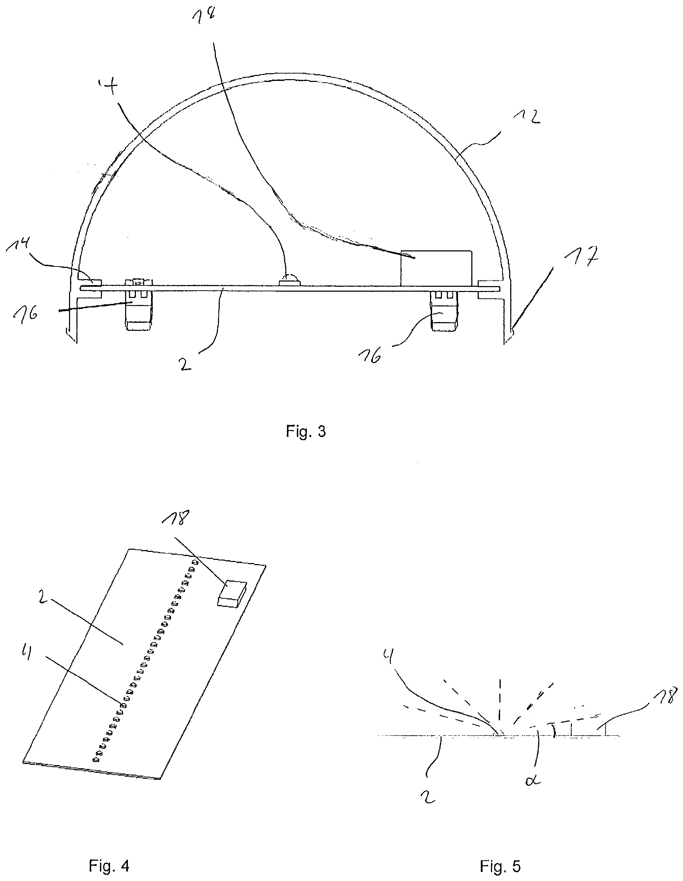

Die Figur 3 zeigt eine Variante der Ausführungsform nach Figur 2. In dieser Ausführungsform ist zusätzlich ein elektronisches Bauteil 18 an dem Träger 2 auf der die LEDs 4 tragenden Oberseite angeordnet. Das elektronische Bauteil 18 ist in dieser Ausführungsform ein LED-Treiber, der mittels der bereits vorhergehend beschriebenen Leiterbahnen auf dem Träger 2 mit den LEDs 4 verbunden ist. Ferner ist das elektronische Bauteil 18 mit einem der Steckverbinder 16 verbunden, um es elektrisch zu versorgen. In dieser Ausführungsform ist die gegenüberliegende Steckverbindung 16 lediglich als mechanische Halterung ausgebildet.

Bezugnehmend auf die Figuren 4 und 5 wird die Anordnung des elektronischen Bauteils 18 auf dem Träger 2 erläutert. Die LEDs 4 auf dem Träger 2 sind in einer Reihe hintereinander angeordnet. Das elektronische Bauteil 18 ist in einem erheblichen Abstand angeordnet, wobei der Abstand abhängig von dem Abstrahlwinkel der LEDs 4 gewählt ist. Wie in Figur 5 dargestellt, ragt das elektronische Bauteil 18 aufgrund seiner Höhe in den Abstrahlbereich der LEDs 4 hinein. Das elektronische Bauteil 18 ist jedoch in einem solchen Abstand zu der nächstliegenden LED 4 angeordnet, dass der Winkel zwischen der Trägerfläche und dem Lichtstrahl, der von der LED 4 ausgeht und das elektronische Bauteil 18 tangiert, nicht mehr als α =10° beträgt. Dadurch wird der Abstrahlbereich der LED nur unwesentlich eingeschränkt. Andererseits hat die Anordnung des elektronischen Bauteils 18 auf der gleichen Seite des Trägers wie die LEDs 4 den Vorteil, dass abgesehen von der einen Steckverbindung 16 keine Durchgangskontaktierung mehr durch das Metallblech 2 erfolgen muss.

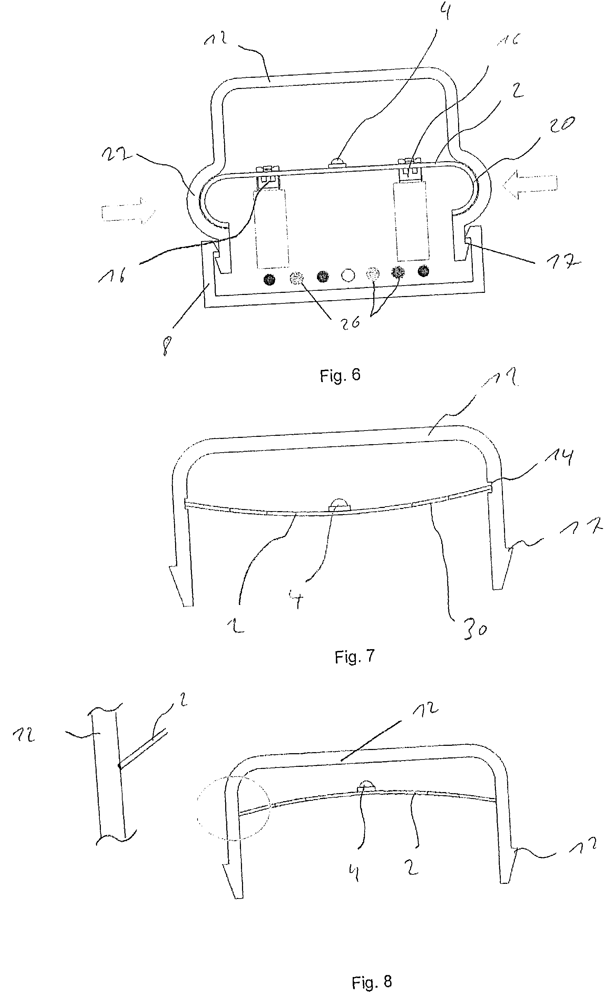

Figur 6 zeigt ein LED-Leuchtenmodul gemäß der Erfindung, in welcher der Träger 2 an den Rändern Umformungen 20 aufweist. Die Umformungen der Ränder erhöhen die Biegefestigkeit des Trägers 2 in der Längsrichtung. Ferner sind sie in der dargestellten Ausführungsform dafür eingerichtet, formschlüssig mit Ausbuchtungen 22 in der Abdeckung 12 zusammenzuwirken, um den Träger 2 in dem Leuchtenmodul zu halten. Die Abdeckung 12 wird mittels der bereits vorhergehend beschriebenen hakenförmigen Kontur 17 an einer Gehäusewanne 8 gehalten. Dabei ist von Vorteil, dass die Kräfte zum Halten des Trägers 2 in der Abdeckung 12 genau entgegengesetzt zu den Kräften zwischen der hakenförmigen Kontur 17 und der Gehäusewanne 8 verlaufen. Durch diese Kombination können die Bauteile zusammengefügt werden ohne dass weitere Befestigungsmittel notwendig sind. Zum Lösen der Verbindung ist es möglich, den Träger 2 beidseitig etwas zu komprimieren, so dass die hakenförmigen Ansätze 17 der Abdeckung 12 auch aus der Gehäusewanne 8 wieder gelöst werden können. Die Gehäusewanne 8 kann als geschlossene Wanne ausgeführt sein. Es ist jedoch möglich, lediglich eine Profilschiene 8 vorzusehen, in welcher die Abdeckung 12 eingesteckt ist.

Ferner sind in der Gehäusewanne 8 noch spannungsführende Leitungen 26 vorgesehen, um über die Steckkontakte 16 die LED 4 mit elektrischer Leistung zu versorgen. Vorzugsweise ist in dieser Ausführungsform die Gehäusewanne 8 als ein durchgehendes Profil ausgebildet, um die spannungsführenden Kabel 26 als Durchgangsverdrahtung entlang dem Profil vorzusehen.

Die Figuren 7 und 8 zeigen weitere LED-Leuchtenmodule gemäß der Erfindung, in welchen der Träger 2 unter Spannung in die Abdeckung 12 eingefügt ist, so dass der Träger 2 in Richtung zur Lichtaustrittsfläche des LED-Leuchtenmoduls eine konkave (Figur 7) oder konvexe (Figur 8) Krümmung aufweist. Der Träger 2 ist in diesen Ausführungsformen mit einer geringeren Wandstärke ausgeführt, z.B. 0,5 mm. Durch die Abdeckung 12 wird eine Vorspannung auf den Träger 2 erreicht, der eine gewünschte definierte Bogenform des Trägers 2 über den gesamten Träger hinweg erzielt. Somit können die lichtlenkenden Eigenschaften des als Reflektor wirkenden Trägers 2 festgelegt werden. Ferner sind in dieser Ausführungsform noch Schlitze 30 in dem Träger 2 vorgesehen, welche einen Anteil des Lichts auf die der Hauptabstrahlrichtung der LEDs entgegengesetzten Seiten auskoppeln. Dieser Lichtanteil kann z.B. zur Ausbildung eines Indirektlichtanteils des LED-Leuchtenmoduls genutzt werden.

In der Ausführungsform nach Figur 7 ist der Träger 2 in gegenüberliegende Nuten 14 der Abdeckung 12 eingeschoben. In der Ausführungsform nach Figur 8 sind demgegenüber keine zusätzlichen Einrichtungen an der Abdeckung 12 notwendig. Die scharfen Kanten des als Blech ausgebildeten Trägers 2 verspreitzten sich in der Abdeckung 12, damit der Träger in der Abdeckung 12 gehalten werden kann.

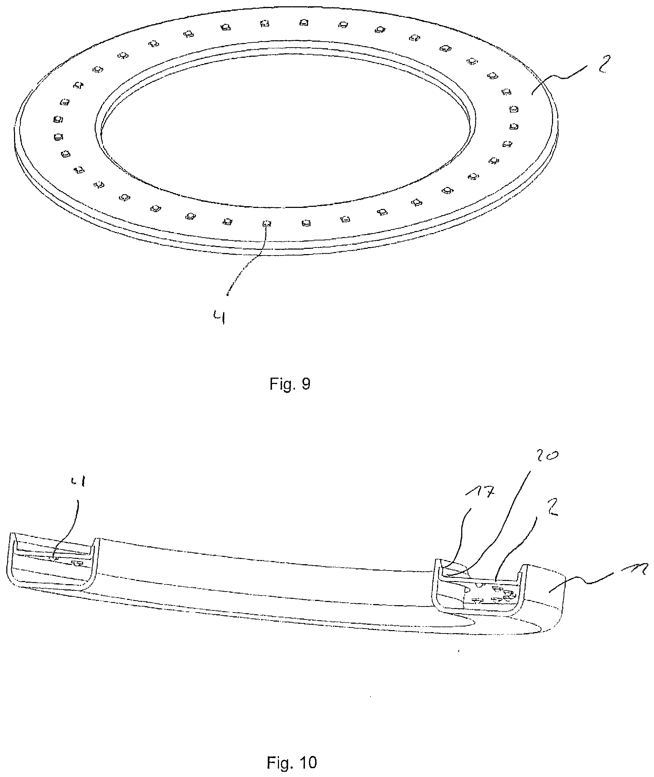

In den Figuren 9 und 10 ist eine weitere Ausführungsform des LED-Leuchtenmoduls dargestellt. In dieser Ausführungsform ist der Träger 2 und die Abdeckung 12 ringförmig ausgebildet. Da auch ein Tiefziehen des bandlackierten Blechs des Trägers 2 möglich ist, können ringförmige Module kostengünstig hergestellt werden. Der Träger 2 kann wie in den vorhergehend beschriebenen Ausführungsformen in der Abdeckung 12 durch einen Kraft- und/oder Formschluss befestigt werden. Auch in dieser Ausführungsform sind integrierte elektrische Bauteile und elektrische Steckverbinder möglich.

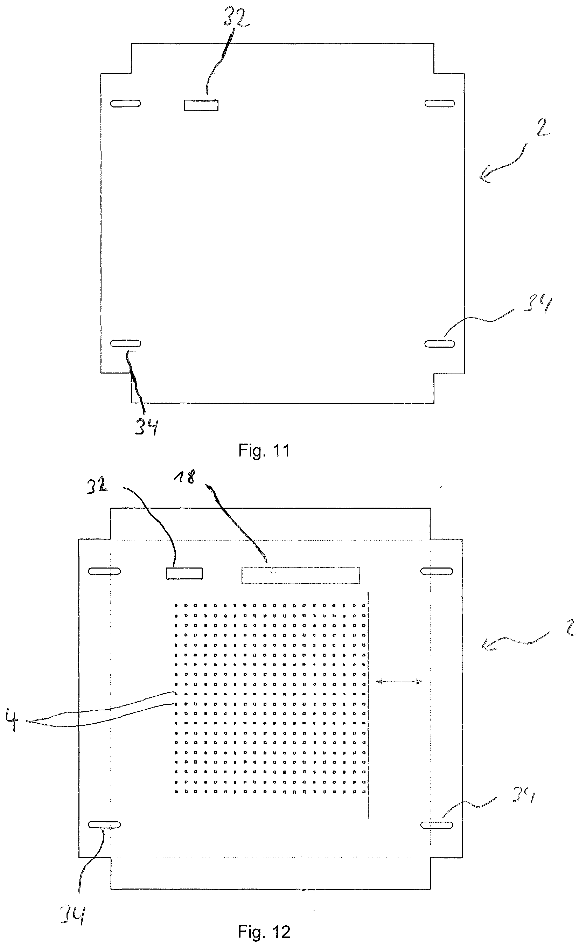

Bezug nehmend auf die Figuren 11 bis 14 wird eine weitere Ausführungsform eines LED-Leuchtenmoduls sowie dessen Herstellung beschrieben.

Der Herstellungsprozess beginnt mit der Bereitstellung eines flächigen Trägers. Der flächige Träger besteht aus einem lackierten Stahlblech. Alternativ kommt auch Aluminiumblech in Betracht. Die Lackierung kann beispielsweise eine Bandlackierung sein. Es kann auch ein Verbundblech mit einer Kunststoffbeschichtung vorgesehen sein. Für eine einfache Isolierung ist eine Lackierung mit einer Stärke zwischen 5 µm und 50 µm ausreichend. Für eine verstärkte Isolation kann auch eine Isolierung mit einer Stärke von 5 µm bis 100 µm vorgesehen sein.

Der Träger 2 ist durch einen Stanzprozess gebildet. Randbereiche des Trägers 2 sind derart geschnitten, dass es sich für einen späteren Umformungsprozess zur Bildung von Seitenwandbereichen des LED-Moduls eignet. Ferner ist in dem Träger 2 bereits eine Durchführung 32 für eine elektrische Klemme sowie Öffnungen 34 für eine Halterung als Deckeneinbauelement integriert. Die elektrische Klemme kann so ausgeführt sein, dass sie Leiterbahnen kontaktiert die auf dem Träger aufgebracht sind. Die elektrische Klemme und Elemente zur Halterung der Leuchte können die Ränder der Öffnungen 32,34 abdecken und insbesondere damit verrastet sein.

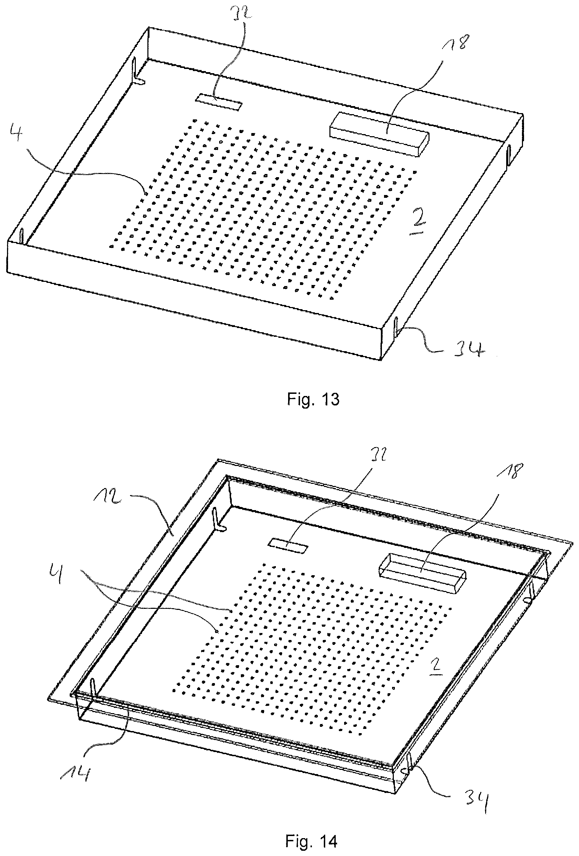

Im nächsten Verfahrensschritt werden auf dem Träger 2 noch vor dem Umformen die LEDs 4 mechanisch angebracht und elektrisch kontaktiert. Dabei ist von Vorteil, dass der Träger noch flach ist. Ferner wird auch ein elektrisches Bauteil 18 in Form eines integrierten Treibers für die LEDs auf dem Träger 2 aufgebracht. Alle elektrischen Bauteile weisen einen ausreichenden Mindestabstand zu den Kantungen auf, welche im nachfolgenden Schritt umgebogen werden. Die Randbereiche des Trägers 2, in der dargestellten Ausführungsform entlang aller vier Ränder, werden in Richtung zur Flächennormalen auf der Fläche der LEDs umgeformt. Das Ergebnis ist in Figur 13 dargestellt. Die Randbereiche des Trägers 2 bilden bei dieser Ausführungsform die Seitenwände des LED-Moduls.

In einem weiteren Verfahrensschritt wird eine wenigstens teilweise transparente Abdeckung 12 auf das Modul aufgesetzt, wie in Figur 14 dargestellt. Die transparente Abdeckung 12 weist auf der zu den Randbereichen des Trägers 2 weisenden Seite integrierte Nuten 14 auf, welche auf die außen liegenden Ränder des Trägers aufgesteckt werden. Diese Art der Verbindung hat den Vorteil, dass sämtliche außen liegende Ränder des Trägers 2 durch die Abdeckung verdeckt werden. Dies ist nicht nur in der Herstellung einfach, sondern bietet ferner den Vorteil, dass die durch den Stanzprozess scharfkantigen Ränder des Trägers 2 gegen Berührung geschützt sind. Einer Verletzungsgefahr wird daher entgegengewirkt. Ferner wird auch ein elektrischer Berührschutz gewährleistet für den Fall, dass der Träger 2 selbst spannungsführend ist. Die Nuten 14 der Abdeckung 12 schließen dicht an den Träger 2 an, so dass auch durch einen Schraubendreher oder einen Draht eine Berührung der frei liegenden Ränder des Trägers 2 verhindert wird. Die Abdeckung 12 kann auch Vorsprünge, insbesondere mit Nuten, aufweisen, die auch die seitlichen Ränder der aufgestellten Seitenwände des Moduls übergreifen und damit abdecken. Die Abdeckung 12 kann über Rastelemente, insbesondere mit einer Rastverbindung zwischen den seitlichen Rändern der Seitenwände oder zwischen den Eckbereichen der Fläche, auf der die LEDs befestigt sind, und den Vorsprüngen der Abdeckung an dem Träger 2 befestigt sein.

Das in den Figuren 11 bis 14 dargestellte LED-Leuchtenmodul eignet sich z.B. als Einlegeleuchte für eine Decke oder als Einlegemodul für eine Anbauleuchte. Der Aufbau des LED-Leuchtenmoduls ist dabei so gebildet, dass er zerstörungsfrei nicht lösbar ist. Dies ist nicht notwendig, da die LEDs und der LED-Treiber wartungsfrei arbeiten und eine verhältnismäßige hohe Lebenszeit aufweisen. Das Modul muss daher nur als Ganzes getauscht werden, falls ein Defekt vorliegt.

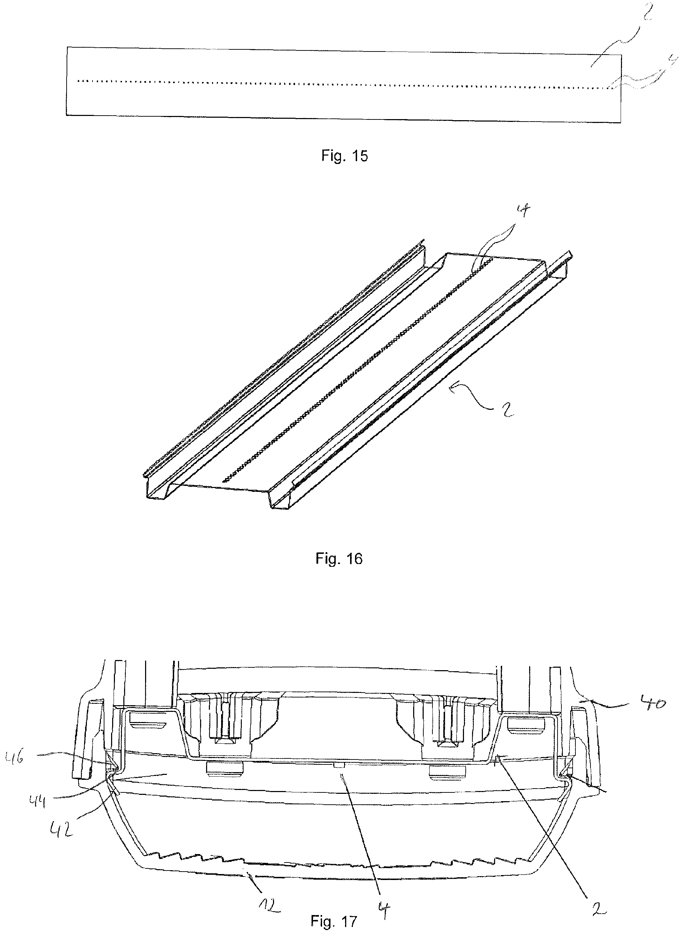

Bezug nehmend auf die Figuren 15 bis 17 wird eine weitere Ausführungsform eines LED-Moduls beschrieben. Dieses LED-Modul ist für eine Leuchte insbesondere für eine Leuchte höhere Schutzart (z.B. IP44 oder höher) ausgebildet.

Der Herstellungsprozess beginnt mit Bereitstellen eines lackierten länglichen Träger 2, der zunächst mit LEDs 4 bestückt wird. Die LEDs 4 können insbesondere in einer Reihe, wie in Figur 15 dargestellt, angeordnet sein und in dieser Reihe auch elektrisch miteinander verbunden sein. Das Aufbringen der LEDs kann entweder eine sich wiederholende Leiterstruktur sein oder endlos erfolgen, wobei endlos präferiert wird aufgrund des einfachen Herstellungsprozesses. Bei der endlosen Bestückung kann vorgesehen sein, dass Trennstellen zwischen den LEDs nicht bestückt sind, um ein Ablängen des Trägers zu ermöglichen. Alternativ können auch definierte Stellen in der Reihe der LEDs durch eine Leitungsbrücke (0-Ohm-Widerstand) ersetzt werden. An dieser Stelle lässt sich der Träger 2 ablängen, ohne dass eine LED zerstört wird.

Vorzugsweise erst nach dem Bestücken des Trägers 2 mit LEDs 4 wird der Träger 2, wie in Figur 16 dargestellt, umgeformt. Die beiden Längsbereiche des Trägers 2 werden mehrfach umgeformt. Beispielsweise können die Kantungen durch einen Rollformprozess gebildet werden. Dieses Verfahren ist insbesondere bei länglichen Trägern 2 wie in der Ausführungsform nach Figuren 15 bis 17 dargestellt, von Vorteil. Alternativ kommen auch andere Verfahren, insbesondere Abkanten, Tiefziehen oder Hydroverformungen in Betracht. Bei Hydroverformungen werden die bereits montierten elektrischen Bauteile, insbesondere die LEDs 4 abgedeckt, um ein Beschädigen der LEDs durch die verwendete Hydroflüssigkeit (z.B. ein Wasser-Öl-Gemisch) zu verhindern.

Der in Figur 16 dargestellte Träger kann anschließend in ein Leuchtengehäuse 40 integriert werden und mit einer Abdeckung 12 versehen werden. Wie in Figur 17 dargestellt, kann die Abdeckung mittels domförmiger Befestigungselemente an Vorsprüngen des Gehäuses 40 angebracht werden. Gemäß einer Ausführungsform können die Befestigungselemente in der gleichen Weise an dem Träger 2 befestigt sein, wie auch die LED. Ferner weist der umgeformte Randbereich des Trägers 2 eine Anlaufschräge 42 und einen rückspringenden Bereich 44 auf. Durch die Elastizität des Metallblechs des Trägers 2 sind diese Bereiche elastisch, so dass eine Abdeckung, z.B. in Form einer optischen Wanne wie in Figur 17 dargestellt, mit Haltenasen 46 auf die Randbereiche des Trägers 2 aufgesteckt werden kann. Vorzugsweise ist zwischen dem Gehäuse 40 und der Abdeckung 12 noch eine Dichtung vorgesehen, um die Leuchte höherer Schutzart zu bilden.

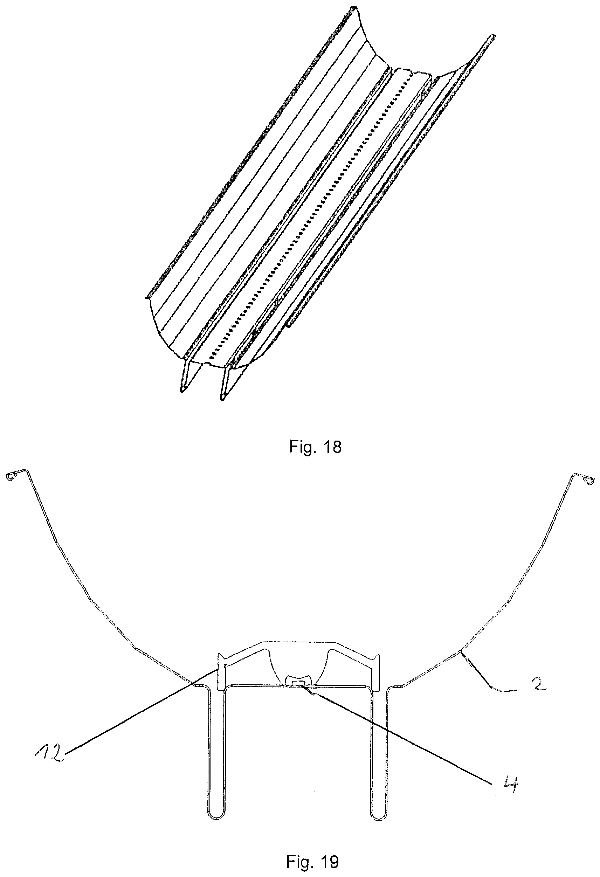

Die Figuren 18 und 19 zeigen weitere LED-Leuchtenmodule gemäß der Erfindung. In diesem Fall ist der Träger 2 im Randbereich mehrfach abgewinkelt in Richtung zur Flächennormalen auf den LEDs umgeformt. Diese Wölbungsstruktur eignet sich insbesondere zur Ausbildung definierter optischer Eigenschaften des Trägers, wenn der Träger als Reflektor genutzt wird. In Figur 19 ist ein Querschnitt durch den Träger 2 dargestellt. Die zu den LEDs 4 gewandten Innenflächen sind vorzugsweise lichtreflektierend ausgebildet. Ferner ist eine Abdeckung in Form einer Primäroptik direkt über den LEDs 4 angebracht. Die in Figur 19 gezeigte integrierte Struktur eignet sich z.B. zum Einsatz in einem Schienensystem, um eine Leuchte zu bilden.

In den vorhergehend beschriebenen Ausführungsformen können zahlreiche Modifikationen vorgenommen werden, ohne von dem Umfang der Erfindung, der durch die Ansprüche definiert ist, abzuweichen. Insbesondere sind die Ausführungsformen auf die konkreten Formen der aus Blech gebildeten Träger und den verschiedenen Abdeckungen nicht eingeschränkt. Vorzugsweise ist jedoch die Abdeckung so ausgebildet, dass sie den Träger 2 auf der mit den LEDs besetzten Seite vollständig ohne Spalte umgibt, so dass ein Berührschutz der elektronischen Bauteile auf dem Träger gewährleistet ist.

Neben den LEDs und dem Treiber, bzw. den elektronischen Komponenten des Treibers, können auch Dioden, Widerstände, 0-Ohm-Widerstände und/oder Kondensatoren auf dem Träger angeordnet und elektrisch kontaktiert sein.

An dem Träger können auch alle Befestigungselemente angebracht sein, die für eine sichere Befestigung an einem Mast oder einer Raumdecke erforderlich sind.

An dem Träger kann auch eine Anschlussmöglichkeit vorgesehen sein, an der eine Netzleitung zur Stromversorgung der elektrischen Komponenten angeschlossen werden kann.

Das LED-Leuchtmodul kann auch als Leuchte ausgeführt sein. Die Leuchte kann eine Außenleuchte, wie z. B. eine Straßenleuchte oder Tunnelleuchte, und eine Innenleuchte, wie z.B. eine Einbauleuchte, Anbauleuchte, Pendelleuchte oder Stehleuchte, sein.

### BEZUGSZEICHENLISTE

- 2: Träger
- 4: LED
- 6: Folie
- 8: Gehäusewanne/Gehäuseboden oder allg. Profilschiene
- 10: Rechteck
- 12: Abdeckung
- 14: Nut
- 16: Steckkontakt
- 17: hakenförmige Kontur
- 18: Elektronisches Bauteil, insbesondere LED-Treiber
- 20: Umformung
- 22: Ausbuchtung
- 26: Leitung
- 30: Schlitz
- 32: Durchführung für Klemme
- 34: Öffnung für Deckenhalterung
- 40: Gehäuse
- 42: Anlaufschräge
- 44: Rücksprung
- 46: Haltenasen

## Patentansprüche

1. LED-Leuchtenmodul, das einen flächigen Träger (2) aufweist, der mit mehreren LEDs (4) bestückt ist,
wobei der Träger aus einem Metallblech gebildet ist, das auf wenigstens einer Oberflächenseite eine elektrisch isolierende Lackierung aufweist,
und die mehreren LEDs (4) direkt auf der Lackierung angeordnet und elektrisch kontaktiert sind, wobei der flächige Träger (2) eine konkave oder konvexe Krümmung aufweist,
**dadurch gekennzeichnet, dass**
der Träger (2) auf der wenigstens einen Oberflächenseite bandlackiert ist, und dass die Lackierung eine Schichtdicke zwischen 5 µm und 80 µm aufweist.

2. LED-Leuchtenmodul nach Anspruch 1, wobei die Lackierung eine Schichtdicke zwischen 10 µm und 35 µm aufweist.

3. LED-Leuchtenmodul nach einem der vorhergehenden Ansprüche, wobei die Lackierung lichtreflektierend ausgebildet ist.

4. LED-Leuchtenmodul nach einem der vorhergehenden Ansprüche, wobei die LEDs (4) mittels auf die Lackierung aufgebrachten metallischen Leiterbahnen elektrisch kontaktiert sind.

5. LED-Leuchtenmodul nach einem der vorhergehenden Ansprüche, welches ferner eine Abdeckung (12) aus einem wenigstens teilweise transparenten Material aufweist und die Abdeckung gegenüberliegenden der wenigstens einen Oberflächenseite angeordnet ist, so dass das Licht der LEDs (4) überwiegend oder vollständig durch die Abdeckung hindurchtritt,
wobei vorzugsweise die Abdeckung (12) mechanisch,
insbesondere formschlüssig, mit dem Gehäusebauteil (8) auf der den LEDs entgegengesetzten Seite des Trägers (2) verbunden ist.

6. LED-Leuchtenmodul nach Anspruch 5, wobei die Abdeckung (12) mit dem Träger derart verbunden ist, dass ein Berührungsschutz der LEDs (4) und der elektrischen Kontaktierung der LEDs gebildet ist.

7. LED-Leuchtenmodul nach Anspruch 5 oder 6, wobei der flächige Träger (2) durch einen Formschluss und/oder einem Kraftschluss mit der Abdeckung verbunden ist, insbesondere in Vor- und/oder Rücksprüngen (14, 22) der Abdeckung (12) geschoben oder eingeklemmt ist.

8. LED-Leuchtenmodul nach einem der vorhergehenden Ansprüche, wobei sich die Krümmung kontinuierlich über den gesamten Träger (2) erstreckt.

9. LED-Leuchtenmodul nach einem der vorhergehenden Ansprüche, wobei an dem Träger (2) wenigstens ein Steckverbinder (16) vorgesehen ist, der sich durch den Träger von der wenigstens einen Oberflächenseite mit den LEDs auf die entgegengesetzte Seite erstreckt und dafür eingerichtet ist, den Träger elektrisch anzuschließen und/oder mechanisch an einer Leuchtenkomponente zu halten.

10. LED-Leuchtenmodul nach einem der vorhergehenden Ansprüche, wobei auf der wenigstens einen Oberflächenseite neben den LEDs (4) eine weitere elektrische Komponente (18) vorgesehen ist, insbesondere ein LED-Treiber, wobei die elektrischen Komponente in einem solchen Abstand zu den LEDs angeordnet ist, dass der Abstrahlwinkel der LEDs (4) durch das weitere elektrische Bauteil nicht oder weniger als 10° eingeschränkt ist.

11. LED-Leuchtenmodul nach einem der vorhergehenden Ansprüche, wobei der flächige Träger (2) an einem oder an mehreren Rändern eine Umformung (22) aufweist.

12. LED-Leuchtenmodul nach einem der vorhergehenden Ansprüche, wobei der flächige Träger (2) streifenförmig oder ringförmig ausgebildet ist.

13. LED-Leuchtenmodul nach einem der vorhergehenden Ansprüche, wobei der flächige Träger (2) eine Stärke zwischen 0,3 mm und 1,2 mm, insbesondere zwischen 0,4 mm und 0,9 mm, aufweist.

14. LED-Leuchtenmodul nach einem der vorhergehenden Ansprüche, wobei der flächige Träger (2) auf der den LEDs (4) entgegengesetzten Seite mit einem Gehäusebauteil (8) verklebt ist,
wobei die Verklebung vorzugsweise durch eine beidseitig klebende Folie gebildet ist.

15. Herstellungsverfahren eines LED-Leuchtenmoduls nach einem der Ansprüche 1 bis 14, welches folgende Schritte umfasst:
Bereitstellen eines flächigen Trägers (2), der aus einem Metallblech gebildet ist, durch Bandlackieren einer elektrisch isolierenden Schicht auf wenigstens einer Oberflächenseite,
Aufbringen elektrisch leitender Bahnen auf der elektrisch isolierenden Lackschicht,
Anordnen von mehreren LEDs auf der Lackierung des flächigen Trägers und elektrisches Kontaktieren der LEDs, und vor oder nach dem Anordnen und dem elektrischen Kontaktieren der LEDs:
Umformen des Randbereichs des flächigen Trägers.

16. Herstellungsverfahren nach Anspruch 15, wobei die umgeformten Bereiche des flächigen Trägers in Richtung zu einer Flächennormalen der mit LEDs besetzten Seite des Trägers umgebogen werden.

17. Herstellungsverfahren nach Anspruch 15 oder 16, wobei der Träger (2) in Bereichen umgeformt wird, welche nicht mit LEDs besetzt sind.

18. Herstellungsverfahren nach einem der Ansprüche 15 bis 17, wobei einer oder mehrere der Randbereiche des Trägers (2) durch Rollformen, durch Abkanten, durch Drücken, durch Tiefziehen oder durch Hydroformen umgeformt werden.

19. Herstellungsverfahren nach einem der Ansprüche 15 bis 18, welches ferner, vorzugsweise vor dem Schritt des Umformens von Rändern des flächigen Trägers (2), ein Anordnen und Kontaktieren eines elektrischen Bauteils (18) für die LEDs auf einem Bereich des flächigen Trägers (2) innerhalb der zu umformenden Randbereiche aufweist.

20. Herstellungsverfahren nach einem der Ansprüche 15 bis 19, welches ferner das Anordnen einer wenigstens teilweise transparenten Abdeckung (12) an dem umgeformten Randbereichen umfasst, insbesondere die äußeren Rändern der Randbereiche verdeckt werden.

21. LED-Leuchtenmodul nach einem der Ansprüche 1 bis 15, welches ferner einen elektrischen Treiber mit einem Netzanschluss zum elektrischen Versorgen der LEDs (4) sowie Befestigungsmittel und vorzugsweise eine Abdeckung (12) aufweist, um eine vollständige Leuchte zu bilden.

## Claims

1. LED lighting module which has a planar carrier (2) which is fitted with a plurality of LEDs (4),
wherein the carrier is formed from a metal sheet which has an electrically insulating coating on at least one surface side,
and the plurality of LEDs (4) is arranged directly on the coating and made electrical contact, wherein the planar carrier (2) has a concave or convex curvature,
**characterized in that**
the carrier (2) is coil-coated on the at least one surface side, and **in that** the coating has a layer thickness of between 5 µm and 80 µm.

2. LED lighting module according to claim 1, wherein the coating has a layer thickness of between 10 µm and 35 µm.

3. LED lighting module according to one of the preceding claims, wherein the coating is of light-reflective design.

4. LED lighting module according to one of the preceding claims, wherein electrical contact is made with the LEDs (4) by means of metallic conductor tracks which are applied to the coating.

5. LED lighting module according to one of the preceding claims, which furthermore has a cover (12) composed of an at least partially transparent material, and the cover is arranged opposite the at least one surface side, such that the light of the LEDs (4) passes predominantly or completely through the cover,
wherein preferably the cover (12) is connected mechanically, in particular in a form-fitting manner, to the housing component (8) on the side of the carrier (2) opposite the LEDs.

6. LED lighting module according to claim 5, wherein the cover (12) is connected to the carrier in such a way that contact protection of the LEDs (4) and the electrical contact-making of the LEDs is formed.

7. LED lighting module according to claim 5 or 6, wherein the planar carrier (2) is connected to the cover by means of a form-fitting connection and/or a force-fitting connection, in particular is pushed or clamped into projections and/or recesses (14, 22) of the cover (12).

8. LED lighting module according to one of the preceding claims, wherein the curvature extends continuously over the entire carrier (2).

9. LED lighting module according to one of the preceding claims, wherein at least one plug-in connector (16) is provided on the carrier (2), which plug-in connector extends through the carrier from the at least one surface side with the LEDs to the opposite side and is designed to electrically connect the carrier and/or to hold it mechanically on a luminaire component.

10. LED lighting module according to one of the preceding claims, wherein a further electrical component (18), in particular an LED driver, is provided on the at least one surface side next to the LEDs (4), wherein the electrical component is arranged at such a distance from the LEDs that the emission angle of the LEDs (4) is not restricted or is restricted by less than 10° by the further electrical component.

11. LED lighting module according to one of the preceding claims, wherein the planar carrier (2) has a shaped portion (22) at one or more edges.

12. LED lighting module according to one of the preceding claims, wherein the planar carrier (2) is of strip-shaped or annular design.

13. LED lighting module according to one of the preceding claims, wherein the planar carrier (2) has a thickness of between 0.3 mm and 1.2 mm, in particular between 0.4 mm and 0.9 mm.

14. LED lighting module according to one of the preceding claims, wherein the planar carrier (2) is adhesively bonded to a housing component (8) on the side opposite the LEDs (4),
wherein the adhesive bond is preferably formed by a film which is adhesive on both sides.

15. Production method of an LED lighting module according to one of claims 1 to 14, which comprises the following steps:
providing a planar carrier (2) which is formed from a metal sheet by coil-coating an electrically insulating layer on at least one surface side,
applying electrically conductive tracks to the electrically insulating coat layer,
arranging a plurality of LEDs on the coating of the planar carrier and making electrical contact with the LEDs,
and before or after arranging and making electrical contact with the LEDs:
shaping the edge region of the planar carrier.

16. Production method according to claim 15, wherein the shaped regions of the planar carrier are bent in the direction of a surface normal of the side of the carrier occupied by LEDs.

17. Production method according to claim 15 or 16, wherein the carrier (2) is shaped in regions which are not occupied by LEDs.

18. Production method according to one of claims 15 to 17,
wherein one or more of the edge regions of the carrier (2) are shaped by roll forming, by folding, by pressing, by deep-drawing or by hydroforming.

19. Production method according to one of claims 15 to 18, which furthermore, preferably before the step of shaping edges of the planar carrier (2), comprises arranging and making electrical contact with an electrical component (18) for the LEDs on a region of the planar carrier (2) within the edge regions to be shaped.

20. Production method according to one of claims 15 to 19, which furthermore comprises arranging an at least partially transparent cover (12) on the shaped edge regions, in particular the outer edges of the edge regions are concealed.

21. LED lighting module according to one of claims 1 to 15, which furthermore has an electrical driver with a mains connection for supplying the LEDs (4) electrically and also fastening means and preferably a cover (12) in order to form a complete luminaire.

## Revendications

1. Module d'éclairage à LED, qui présente un support plat (2) qui est équipé de plusieurs LED (4),
dans lequel le support est formé à partir d'une plaque de métal qui présente un vernis isolant électriquement sur au moins un côté en surface,
et les plusieurs LED (4) sont disposées directement sur le vernis et sont branchées électriquement, dans lequel le support plat (2) présente une courbure concave ou convexe,
**caractérisé en ce que**
le support (2) est peint en bande sur l'au moins un côté en surface, et **en ce que** le vernis présente une épaisseur de couche comprise entre 5 µm et 80 µm.

2. Module d'éclairage à LED selon la revendication 1, dans lequel le vernis présente une épaisseur de couche comprise entre 10 µm et 35 µm.

3. Module d'éclairage à LED selon l'une quelconque des revendications précédentes, dans lequel le vernis est réalisé de manière à réfléchir la lumière.

4. Module d'éclairage à LED selon l'une quelconque des revendications précédentes, dans lequel les LED (4) sont branchées électriquement au moyen de pistes conductrices métalliques appliquées sur le vernis.

5. Module d'éclairage à LED selon l'une quelconque des revendications précédentes, qui présente en outre un couvercle (12) en un matériau au moins partiellement transparent et le couvercle est disposé à l'opposé de l'au moins un côté en surface, de sorte que la lumière des LED (4) passe principalement ou complètement à travers le couvercle,
dans lequel de préférence le couvercle (12) est relié mécaniquement, en particulier par complémentarité de forme, au composant de boîtier (8) sur le côté du support (2) opposé aux LED.

6. Module d'éclairage à LED selon la revendication 5, dans lequel le couvercle (12) est relié au support de telle manière à former une protection contre tout contact des LED (4) et le branchement électrique des LED.

7. Module d'éclairage à LED selon la revendication 5 ou 6, dans lequel le support plat (2) est relié au couvercle par complémentarité de forme et/ou par complémentarité de force, en particulier est poussé ou serré dans des saillies et/ou des retraits (14, 22) du couvercle (12).

8. Module d'éclairage à LED selon l'une quelconque des revendications précédentes, dans lequel la courbure s'étend en continu sur l'ensemble du support (2).

9. Module d'éclairage à LED selon l'une quelconque des revendications précédentes, dans lequel au moins un connecteur enfichable (16) est prévu sur le support (2), lequel s'étend à travers le support depuis l'au moins un côté en surface avec les LED jusqu'au côté opposé et est conçu pour raccorder électriquement le support et/ou le maintenir mécaniquement sur un composant d'éclairage.

10. Module d'éclairage à LED selon l'une quelconque des revendications précédentes, dans lequel un autre composant électrique (18), en particulier un pilote de LED, est prévu sur l'au moins un côté en surface à côté des LED (4), dans lequel le composant électrique est disposé à une distance des LED telle que l'angle de rayonnement des LED (4) n'est pas limité ou est limité à moins de 10° par l'autre composant électrique.

11. Module d'éclairage à LED selon l'une quelconque des revendications précédentes, dans lequel le support plat (2) présente une déformation (22) au niveau d'un ou de plusieurs bords.

12. Module d'éclairage à LED selon l'une quelconque des revendications précédentes, dans lequel le support plat (2) est réalisé en forme de bande ou en forme d'anneau.

13. Module d'éclairage à LED selon l'une quelconque des revendications précédentes, dans lequel le support plat (2) présente une épaisseur comprise entre 0,3 mm et 1,2 mm, en particulier entre 0,4 mm et 0,9 mm.

14. Module d'éclairage à LED selon l'une quelconque des revendications précédentes, dans lequel le support plat (2) est collé sur le côté opposé aux LED (4) à un composant de boîtier (8),
dans lequel le collage est formé de préférence par une feuille adhésive double faces.

15. Procédé de fabrication d'un module d'éclairage à LED selon l'une quelconque des revendications 1 à 14, lequel comprend les étapes suivantes :
le mise à disposition d'un support plat (2) qui est formé à partir d'une plaque de métal par peinture en bande d'une couche isolante électriquement sur au moins un côté en surface,
l'application de pistes électriquement conductrices sur la couche de vernis isolante électriquement,
la disposition de plusieurs LED sur le vernis du support plat et la branchement électrique des LED,
et avant ou après la disposition et le branchement électrique des LED :
la déformation de la zone de bordure du support plat.

16. Procédé de fabrication selon la revendication 15, dans lequel les zones déformées du support plat sont repliées en direction d'une normale à la surface du côté du support occupé par des LED.

17. Procédé de fabrication selon la revendication 15 ou 16, dans lequel le support (2) est déformé dans des zones qui ne sont pas occupées par des LED.

18. Procédé de fabrication selon l'une quelconque des revendications 15 à 17, dans lequel une ou plusieurs des zones de bordure du support (2) sont déformées par formage au rouleau, par pliage, par pressage, par emboutissage profond ou par hydroformage.

19. Procédé de fabrication selon l'une quelconque des revendications 15 à 18, qui présente en outre, de préférence avant l'étape de déformation de bords du support plat (2), une disposition et un branchement d'un composant électrique (18) pour les LED sur une zone du support plat (2) à l'intérieur des zones de bordure à déformer.

20. Procédé de fabrication selon l'une quelconque des revendications 15 à 19, qui comprend en outre la disposition d'un couvercle au moins partiellement transparent (12) au niveau des zones de bordure déformées, dans lequel les bords extérieurs des zones de bordure sont en particulier recouverts.

21. Module d'éclairage à LED selon l'une quelconque des revendications 1 à 15, qui présente en outre un pilote électrique avec une connexion au réseau pour l'alimentation électrique des LED (4) ainsi que des moyens de fixation et de préférence un couvercle (12) pour former un luminaire complet.
